# EUROPÄISCHE PATENTANMELDUNG

(11) **EP 3 301 760 A1**
(43) Veröffentlichungstag der Anmeldung: **04.04.2018**
(21) Anmeldenummer: 17192345.1
(22) Anmeldetag: 21.09.2017
(51) Int. Cl.: H01R 12/71, H01Q 1/08, H01Q 1/12, H05K 3/32, H01Q 1/14

(54) **KONTAKTIERUNG ZWISCHEN EINER ANTENNENSTRUKTUR UND EINER LEITERPLATTE**

(30) Priorität: 22.09.2016 DE 102016117905
(71) Anmelder: Hirschmann Car Communication GmbH, 72654 Neckartenzlingen (DE)
(72) Erfinder: Silva, David, 72622 Nürtingen (DE)
(74) Vertreter: Greif, Thomas

(57) **Zusammenfassung**

Vorrichtung (1), aufweisend eine Leiterplatte (2) und ein Antennengebilde mit einem elektrisch leitfähigen Endbereich (3), zur Kontaktierung der Leiterplatte (2) mit dem Endbereich (3) des Antennengebildes, insbesondere einer Stabantenne, dadurch gekennzeichnet, dass die Leiterplatte (2) eine Öffnung (4) mit Kontaktbereichen aufweist und der Endbereich (3) des Antennengebildes mindestens eine Umbiegung (6) aufweist, wobei zwei Kontaktbereiche des Endbereiches (3) mit der elektrischen Kontaktierung (5) der Öffnung (4) der Leiterplatte (2) unter Federwirkung elektrisch in Verbindung stehen.

## Beschreibung

Die Erfindung betrifft eine Vorrichtung zur Kontaktierung eines Antennenfußes einer Antenne mit einer Leiterplatte gemäß den Merkmalen des Patentanspruches 1.

Antennen, beispielsweise Stabantennen, haben einen Antennenfuß, der mit einem Kontaktbereich auf einer Leiterplatte (oder vergleichbaren Ausgestaltungen) zwecks Signalübertragung kontaktiert werden muss.

Bei Stabantennen ist es schon bekannt geworden, dass der Fußpunkt als zylinderförmiger Leiter, beispielsweise aus Kupfer, ausgebildet ist und durch eine Öffnung in der Leiterplatte geführt wird, wobei danach der Endbereich beispielsweise des Kupferdrahtes mit einer Kontaktfläche um die Öffnung in der Leiterplatte herum verlötet wird. Aufgrund des Lötprozesses ist zwar eine elektrische Kontaktsicherheit gegeben. Jedoch ist aufgrund der rauen Umgebungsbedingungen, in denen solche Antennen zum Beispiel in Fahrzeugen eingesetzt werden, keine dauerhafte Kontaktierung gegeben, da es insbesondere aufgrund von Vibrationen, Temperaturunterschieden und dergleichen zu Brüchen in der Lötstelle kommen kann.

Eine weitere Lösung ist dahingehend bekannt, dass der Endbereich des Antennenfußpunktes ebenfalls aus einem Draht, jedoch aus Edelstahl besteht. Dieses Material hat gegenüber einem Kupferdraht den Vorteil, dass es hinsichtlich der rauen Umgebungsbedingungen wesentlich widerstandsfähiger ist. Dies gilt nicht nur für die Kontaktstelle im Bereich der Leiterplatte, sondern für das gesamte Antennengebilde. Allerdings lässt sich Edelstahl nicht ohne Weiteres im Bereich der Kontaktfläche auf der Leiterplatte verlöten, so dass der Kontaktbereich des Edelstahl-Drahtes mittels einer Säure vorbehandelt, das heißt aufgeraut werden muss, damit dieser Kontaktbereich verlötet werden kann. Dies stellt einen zusätzlichen Arbeitsschritt dar und ist unter umwelttechnischen Aspekten von Nachteil.

Der Erfindung liegt daher die Aufgabe zugrunde, eine Kontaktierung eines Antennenfußes eines Antennengebildes mit einem zugehörigen Kontaktbereich einer Leiterplatte bereitzustellen, wodurch die eingangs geschilderten Nachteile vermieden werden.

Diese Aufgabe ist durch die Merkmale des Patentanspruches 1 gelöst.

Erfindungsgemäß ist vorgesehen, dass der Endbereich des Antennenfußpunktes länglich zylinderförmig ausgebildet und mindestens einmal umgebogen ist, wobei der umgebogene Bereich federnd in einer Öffnung, die elektrisch leitfähige Bereiche aufweist, in der Leiterplatte festgelegt ist. Diese Ausgestaltung hat den Vorteil, dass Lötprozesse (oder vergleichbare stoffschlüssige Prozesse) vermieden werden. Außerdem ist eine Vorbehandlung des Kontaktbereiches weder des Endbereiches des Antennengebildes noch des Kontaktbereiches in der Leiterplatte erforderlich. Weiterhin können für die Kontaktfläche der Leiterplatte und des Fußpunktes des Antennengebildes unterschiedliche Materialien zum Einsatz kommen. Die federnde Anordnung und Anlage des Kontaktbereiches des Antennenfußpunktes an der Kontaktfläche der Leiterplatte mittels Form- beziehungsweise Kraftschluss hat darüber hinaus den wesentlichen Vorteil, dass eine wenn auch nur geringe relative Bewegung zwischen diesen beiden Elementen gegeben ist, so dass dadurch die Kontaktsicherheit dauerhaft erhöht wird, da dann, falls sich Korrosionen an den Oberflächen der Kontaktflächen bilden oder sich Schmutzpartikel dazwischen befinden sollten, diese durch die Relativbewegung immer wieder beseitigt werden. Es wird also bewusst eine Relativbewegung zwischen den Kontaktpartnern zugelassen.

Weitere vorteilhafte Ausgestaltungen sind in den Unteransprüchen definiert und werden im Zusammenhang mit einem Ausführungsbeispiel näher erläutert.

In Weiterbildung der Erfindung ist vorgesehen, dass zumindest der Endbereich des Antennengebildes aus Edelstahl besteht. Dadurch lässt sich dieser Endbereich sehr gut durch einen Form- beziehungsweise Kraftschluss mit dem Kontaktbereich der Leiterplatte kontaktieren. Gleichzeitig widersteht das Antennengebilde den rauen Umgebungsbedingungen aufgrund der Verwendung von Edelstahl und es wird trotzdem ein chemischer Prozess zum Aufrauen vermieden.

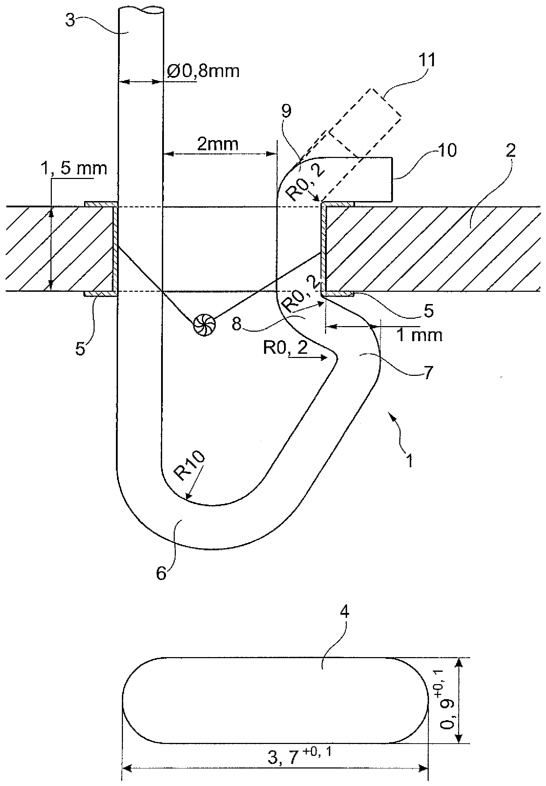

Ein Ausführungsbeispiel der Erfindung ist in der Figur gezeigt.

Mit 1 ist die Kontaktierung einer Leiterplatte 2 mit einem Endbereich 3 eines wie auch immer gearteten Antennengebildes, zum Beispiel einer Stabantenne, bezeichnet. Der Endbereich 3 ist vorzugsweise als länglicher zylinderförmiger Bereich, insbesondere als Draht, ausgebildet. In der Leiterplatte 2 ist eine Öffnung 4, insbesondere eine längliche Öffnung mit Rundungen in ihrem Endbereich, eingebracht. Zumindest um die Randbereiche dieser Öffnung 4 in der Leiterplatte 2, gegebenenfalls auch sich erstreckend bis in Richtung der einen und / oder anderen Oberfläche der Leiterplatte 2, ist eine Kontaktierung 5, welches elektrisch leitend ist, eingebracht. Die Kontaktierung 5 ist entweder ein separates Bauteil in Bezug auf die Leiterplatte 2 oder es handelt sich um eine Beschichtung um die Randbereiche in der Öffnung 4 (und gegebenenfalls darüber hinaus) der Leiterplatte 2.

In einer ersten Ausgestaltung ist der Endbereich 3 zumindest einmal umgebogen, so dass sich der umgebogene Schenkel des Endbereiches 3 in etwa parallel zu dem weiterführenden Schenkel des Endbereiches 3 erstreckt. Diese U-förmige Ausgestaltung wird in die Öffnung 4 eingesetzt, so dass sich dieser umgebogene Endbereich mit seinen beiden Schenkeln an den beiden Randbereichen der elektrischen Kontaktierung 5 in der Öffnung 4 der Leiterplatte 2 federnd anlegt.

In der in der Figur gezeigten Ausgestaltung ist der Endbereich 3 in einem Bereich 6 umgebogen, dem sich eine weitere Umbiegung 7 und noch eine weitere Umbiegung 8 sowie eine letzte Umbiegung 9 anschließt. Durch diese in der Figur dargestellte Ausgestaltung des Endbereiches 3 wird dieser besonders gut in der Öffnung 4
festgelegt, da sich zum Einen die Kontaktbereiche des Endbereiches 3 sehr gut planparallel an die elektrische Kontaktierung 5 anlegen und gleichzeitig vorzugsweise durch die Umbiegungen 8 und 9 sichergestellt ist, dass sich der Endbereich 3 nicht bezogen auf die Oberfläche der Leiterplatte 2 bei Betrachtung der Figur nach oben oder unten bewegen kann. Trotzdem ist eine Relativbewegung zwischen dem Endbereich 3 mit seinen Umbiegungen 6 bis 9 relativ zu der elektrischen Kontaktierung 5 gewährleistet. Der teilweise unterschiedliche Richtungswechsel der Umbiegungen 6 bis 9 ist wichtig und kann ohne Weiteres den Figuren entnommen werden.

Der abschließende Endbereich nach der Umbiegung 9 liegt entweder planparallel zu der Oberfläche der Leiterplatte 2 (Endbereich 10), kann alternativ dazu aber in einem gewissen Winkel abstehen (gestrichelte Darstellung, Endbereich 11).

Die in der Figur angeführten Bemaßungen sind rein beispielhaft, wobei dieses Ausführungsbeispiel im Maßstab 20:1 dargestellt ist. Die Bemaßungen und der Maßstab stellen jedoch keinerlei Einschränkung für diese Erfindung dar.

### Bezugszeichenliste

- 1.: Kontaktierung
- 2.: Leiterplatte
- 3.: Endbereich
- 4.: Öffnung
- 5.: Kontaktierung
- 6.: Umbiegung
- 7.: Umbiegung
- 8.: Umbiegung
- 9.: Umbiegung
- 10.: Endbereich
- 11.: Endbereich

## Patentansprüche

1. Vorrichtung (1), aufweisend eine Leiterplatte (2) und ein Antennengebilde mit einem elektrisch leitfähigen Endbereich (3), zur Kontaktierung der Leiterplatte (2) mit dem Endbereich (3) des Antennengebildes, insbesondere einer Stabantenne, **dadurch gekennzeichnet, dass** die Leiterplatte (2) eine Öffnung (4) mit Kontaktbereichen aufweist und der Endbereich (3) des Antennengebildes mindestens eine Umbiegung (6) aufweist, wobei zwei Kontaktbereiche des Endbereiches (3) mit der elektrischen Kontaktierung (5) der Öffnung (4) der Leiterplatte (2) unter Federwirkung elektrisch in Verbindung stehen.

2. Vorrichtung (1) nach Anspruch 1, **dadurch gekennzeichnet, dass** der Endbereich (3) als länglicher zylinderförmiger Bereich, insbesondere als Draht, ausgebildet ist.

3. Vorrichtung (1) nach Anspruch 1 oder 2, **dadurch gekennzeichnet, dass** zumindest um die Randbereiche der Öffnung (4) in der Leiterplatte (2), gegebenenfalls auch sich erstreckend bis in Richtung der einen und / oder anderen Oberfläche der Leiterplatte (2), ein Kontaktelement (5), welches elektrisch leitend ist, eingebracht ist.

4. Vorrichtung (1) nach Anspruch 3, **dadurch gekennzeichnet, dass** das Element (5) ein separates Bauteil in Bezug auf die Leiterplatte (2) ist.

5. Vorrichtung (1) nach Anspruch 3, **dadurch gekennzeichnet, dass** das Element (5) eine Beschichtung um die Randbereiche in der Öffnung (4) und gegebenenfalls darüber hinaus der Leiterplatte (2) ist.

6. Vorrichtung (1) nach einem der vorhergehenden Ansprüche, **dadurch gekennzeichnet, dass** der Endbereich (3) zumindest einmal umgebogen und damit etwa U-förmig geformt ist, so dass sich der umgebogene Schenkel des Endbereiches (3) in etwa parallel zu dem weiterführenden Schenkel des Endbereiches (3) erstreckt.

7. Vorrichtung (1) nach einem der vorhergehenden Ansprüche, **dadurch gekennzeichnet, dass** der Endbereich (3) in einem weiteren Bereich eine Umbiegung (6) aufweist, der sich eine weitere Umbiegung (7) und noch eine weitere Umbiegung (8) sowie eine letzte Umbiegung (9) anschließt.

8. Vorrichtung (1) nach Anspruch 7, **dadurch gekennzeichnet, dass** ein abschließender Endbereich (10) nach der Umbiegung (9) planparallel zu der Oberfläche der Leiterplatte (2) ausgerichtet und angeordnet ist.

9. Vorrichtung (1) nach Anspruch 7, **dadurch gekennzeichnet, dass** ein abschließender Endbereich (11) nach der Umbiegung (9) in einem gewissen Winkel von der Oberfläche der Leiterplatte (2) abstehend ausgerichtet und angeordnet ist.

10. Vorrichtung (1) nach einem der vorhergehenden Ansprüche, **dadurch gekennzeichnet, dass** zumindest der Endbereich (3) des Antennengebildes aus Edelstahl besteht.
